(19) Europäisches Patentamt
European Patent Office
Office européen des brevets

(11) **EP 3 627 707 B1**

(12) **FASCICULE DE BREVET EUROPEEN**

(45) Date de publication et mention
de la délivrance du brevet:
**17.03.2021 Bulletin 2021/11**

(51) Int Cl.:
***H03L 7/24*** *(2006.01)*     ***H03B 28/00*** *(2006.01)*
***G06F 1/02*** *(2006.01)*

(21) Numéro de dépôt: **19197640.6**

(22) Date de dépôt: **17.09.2019**

(54) **DISPOSITIF DE SYNTHÈSE DE FRÉQUENCE À RANG DE MULTIPLICATION ÉLEVÉ**

FREQUENZSYNTHESEVORRICHTUNG MIT EINEM HOHEN MULTIPLIKATIONSNIVEAU

FREQUENCY SYNTHESIS DEVICE WITH HIGH MULTIPLICATION RANGE

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **19.09.2018 FR 1858472**

(43) Date de publication de la demande:
**25.03.2020 Bulletin 2020/13**

(73) Titulaire: **COMMISSARIAT À L'ÉNERGIE
ATOMIQUE ET AUX
ÉNERGIES ALTERNATIVES
75015 Paris (FR)**

(72) Inventeurs:
• **JANY, Clément
38054 GRENOBLE CEDEX 9 (FR)**
• **HAMEAU, Frédéric
38054 GRENOBLE CEDEX 09 (FR)**
• **SILIGARIS, Alexandre
38054 GRENOBLE CEDEX 09 (FR)**

(74) Mandataire: **Brevalex
56, Boulevard de l'Embouchure
B.P. 27519
31075 Toulouse Cedex 2 (FR)**

(56) Documents cités:
**FR-A1- 2 983 370     FR-A1- 3 006 131**

• **JANY CLEMENT ET AL: "A Programmable
Frequency Multiplier-by-29 Architecture for
Millimeter Wave Applications", IEEE JOURNAL
OF SOLID-STATE CIRCUITS, IEEE SERVICE
CENTER, PISCATAWAY, NJ, USA, vol. 50, no. 7,
1 juillet 2015 (2015-07-01), pages 1669-1679,
XP011585481, ISSN: 0018-9200, DOI:
10.1109/JSSC.2015.2411623 [extrait le
2015-06-23]**

Remarques:
Le dossier contient des informations techniques
présentées postérieurement au dépôt de la demande
et ne figurant pas dans le présent fascicule.

**Description**

**DOMAINE TECHNIQUE**

La présente invention s'applique de manière générale au domaine des dispositifs de synthèse de fréquence élevée à faible bruit de phase et faible consommation. Elle trouve notamment application dans les prochaines générations de systèmes de télécommunication utilisant la bande non-licenciée autour de 60 GHz.

**ÉTAT DE LA TECHNIQUE ANTÉRIEURE**

Les prochains systèmes de télécommunication utiliseront la gamme de fréquence millimétrique et devront pour la plupart être capables d'accéder de manière opportuniste à la bande non-licenciée autour 60 GHz. Toutefois, le déploiement de ces systèmes suppose que l'on puisse réaliser des oscillateurs à faible bruit de phase et faible consommation dans cette gamme de fréquence.

Des candidats adaptés à cette fin sont le dispositif décrit dans la publication de brevet FR3006131 A1, et le dispositif de synthèse de fréquence à faible bruit de phase et faible consommation décrit dans la demande FR-A-2 983 370 déposée au nom de la présente demanderesse.

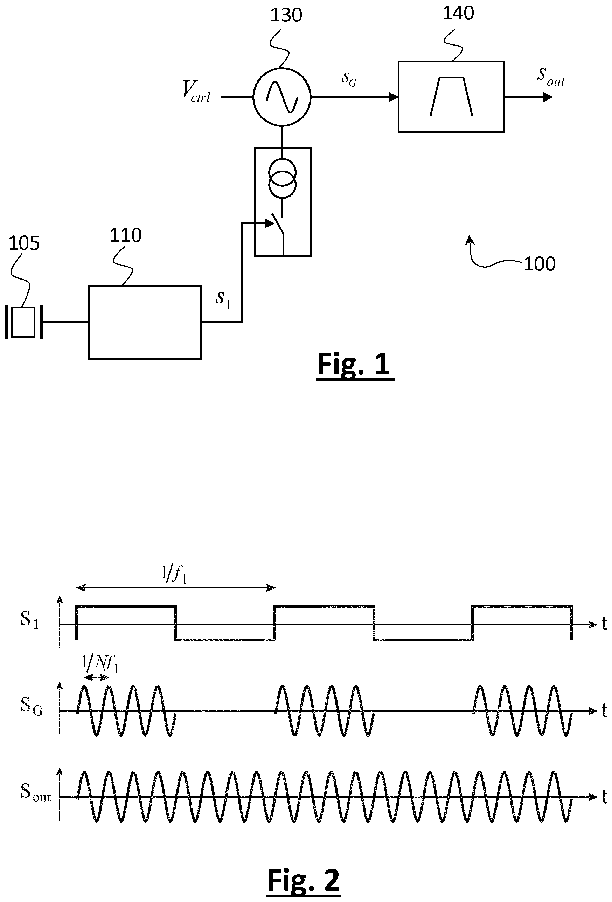

Ce dispositif, 100, a été représenté schématiquement en Fig. 1. Il comprend un générateur d'une fréquence de base $f_1$, 110, stable en fréquence et en phase. Ce générateur peut par exemple utiliser un signal de basse fréquence périodique de référence stable en fréquence et en phase fourni par un résonateur à quartz, 105, comme indiqué sur la figure. Dans ce cas, le générateur 110 comprend un oscillateur de type VCO et une boucle de verrouillage de phase (PLL) asservissant la fréquence $f_1$ de l'oscillateur VCO à un sous-multiple de la fréquence du résonateur, $f_{quartz}$. Alternativement, le générateur de fréquence de base peut être simplement le signal issu d'un résonateur à quartz stabilisé en température à la fréquence $f_1$.

Le signal de base, $s_1$, fourni par le générateur 110 est un signal carré (dont le rapport cyclique n'est pas nécessairement égal à 1/2). Il sert à commuter la source d'alimentation (en courant ou en tension) d'un oscillateur 130 de type VCO dont la fréquence est commandée par une tension de contrôle $V_{ctrl}$. L'interruption périodique à la fréquence $f_1$ de l'oscillateur 130 verrouille ce dernier sur une harmonique d'ordre $N$ de $f_1$ telle que $Nf_1 \approx f_G$ où $f_G$ est la fréquence en régime d'oscillation libre (c'est-à-dire en régime non commuté) de l'oscillateur 130, correspondant à la tension de contrôle $V_{ctrl}$. L'ordre de l'harmonique sur lequel se verrouille l'oscillateur est donc fonction de la tension de contrôle.

La Fig. 2 représente un chronogramme de signaux présents en différents points du dispositif de synthèse de fréquence de la Fig. 1.

La première ligne correspond au signal de base $s_1$ (supposé sur la figure de rapport cyclique 1/2), de fréquence $f_1$, en sortie du générateur de fréquence de base 110.

La seconde ligne correspond au signal $s_G$ en sortie de l'oscillateur à alimentation commutée 130. Il se présente sous la forme d'oscillations sinusoïdales pulsées, c'est-à-dire sous la forme de trains d'ondes, la fréquence de répétition de ces trains étant égale à la fréquence $f_1$ et la fréquence des oscillations sinusoïdales étant égale à $Nf_1$. Les oscillations des différentes impulsions démarrent toutes avec une même phase initiale.

Le spectre $S_1$ du signal $s_1$ est un spectre de raies possédant une forme générale de sinus cardinal. Plus précisément, le spectre $S_1$ peut s'exprimer sous la forme :

$$S_1(f) = \left( \mathrm{sinc}\left( \pi \frac{f}{f_w} \right) \bigcap \left( \frac{f}{f_1} \right) \right) \tag{1}$$

où sine est la fonction sinus cardinal, $f_w = 1/T_w$ où $T_w$ est la largeur du créneau d'une impulsion se répétant à la fréquence $f_1$ dans le signal $s_1$, $\bigcap \left( \frac{f}{f_1} \right) = \sum_{k=-\infty}^{+\infty} \delta(f - kf_1)$ (où $\delta$ est la fonction de Dirac) est un peigne de Dirac dont les raies sont espacées de $f_1$.

Le spectre $S_G$ du signal $s_G$ n'est autre que le même spectre de raies décalé de $f_G = Nf_1$ :

$$S_G(f) = \left( \mathrm{sinc}\left( \pi \frac{f - Nf_1}{f_w} \right) \bigcap \left( \frac{f}{f_1} \right) \right) \tag{2}$$

Le signal $s_G$ fait ensuite l'objet d'un filtrage passe-bande de très haute sélectivité dans un circuit de récupération de fréquence, 140, pour ne sélectionner que la raie à la fréquence $Nf_1$. Ce circuit de récupération de fréquence se présente sous la forme d'un oscillateur verrouillé par injection ou ILO (*Injection Locked Oscillator*) tel que décrit par exemple dans l'article de M. Tiebout intitulé « A 50 GHz direct injection locked oscillator topology as low power frequency divider in 0.13 μm CMOS » publié dans Proc. of the 29th European Solid State Circuits Conference, pp. 73-76, 16-18 Sept. 2003.

Le signal, $s_{out}$, en sortie du circuit récupérateur de fréquence est un signal sinusoïdal continu de fréquence $Nf_1$ stable en fréquence et en phase, comme représenté en dernière ligne de la Fig. 2.

Le dispositif de synthèse de fréquence représenté en Fig. 1 ne permet cependant pas d'atteindre des ordres de multiplication très élevés. En effet, le verrouillage de l'oscillateur ILO sur une harmonique n'intervient que si la puissance de cette harmonique est supérieure à une puissance minimale. Or, la puissance d'une harmonique dans le signal $s_G$ décroît selon une loi en sinus cardinal à partir de la fréquence centrale. On peut envisager de réduire le rapport cyclique de $s_1$ pour élargir le lobe principal du sinus cardinal mais, dans ce cas, les trains d'ondes sont courts et le verrouillage de l'oscillateur ILO n'est pas assuré.

Une première solution pour s'affranchir de cette limitation est de cascader plusieurs étages de synthèse de fréquence du type représenté en Fig. 1, chaque étage servant à générer le signal de base de l'étage suivant.

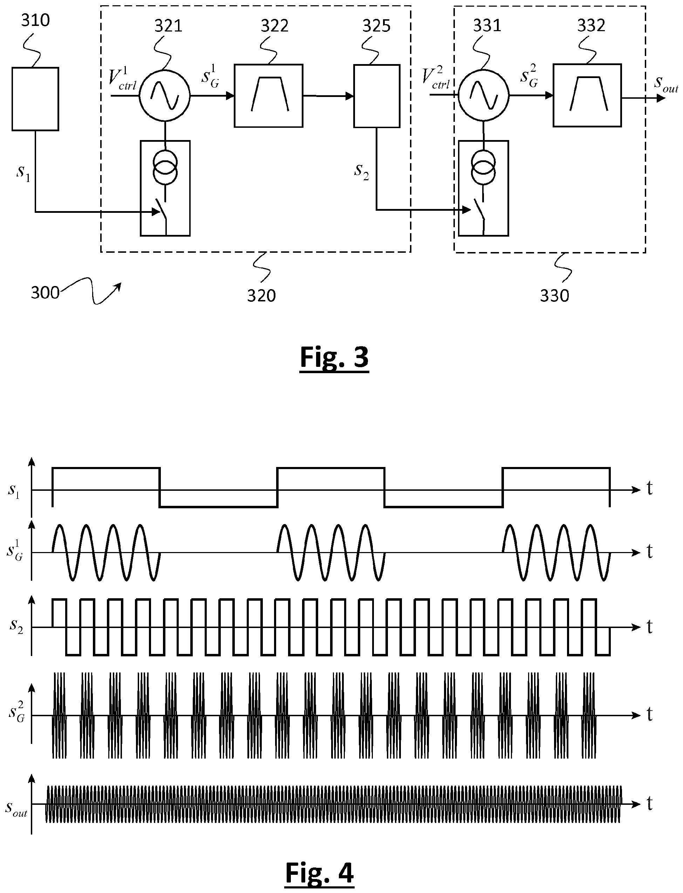

La Fig. 3 représente de manière schématique un dispositif de synthèse de fréquence faisant appel à une mise en cascade de deux étages de synthèse de fréquence du type de la Fig. 1.

Ce dispositif 300 comprend un générateur de fréquence de base, 310, identique au générateur 110, suivi d'un premier étage de synthèse de fréquence, 320, et d'un second étage de synthèse de fréquence, 330. Le premier étage de synthèse de fréquence est composé d'un premier oscillateur à alimentation commutée, 321, et d'un premier circuit de récupération de fréquence, 322. Le second étage, 330, comprend de manière similaire un second oscillateur à alimentation commutée, 331, et un second circuit de récupération de fréquence, 332.

Le signal sinusoïdal de sortie, $s_{out}^1$, du premier étage de synthèse de fréquence est mis sous forme carrée dans le circuit de mise en forme, 325. Le signal périodique en sortie du circuit de mise en forme, à la fréquence fondamentale $f_2 = Nf_1$, sert à commuter l'alimentation du second oscillateur, 331. Ce second oscillateur se verrouille en phase sur une harmonique de fréquence $Mf_2 = NMf_1 \approx f_G^2$ où $f_G^2$ est la fréquence propre (c'est-à-dire en régime d'oscillation libre) de l'oscillateur 331 à la tension de commande $V_{ctrl}^2$.

La Fig. 4 représente un chronogramme de signaux présents en différents points du dispositif de synthèse de fréquence de la Fig. 3.

La première ligne correspond au signal $s_1$ en sortie du générateur de fréquence de base.

La seconde ligne correspond au signal $s_G^1$, en sortie du premier oscillateur à alimentation commutée 321.

La troisième ligne correspond au signal $s_2$, en sortie du circuit de mise en forme 325.

La quatrième ligne correspond au signal $s_G^2$, en sortie du second oscillateur à alimentation commutée 331.

La dernière ligne correspond au signal $s_{out}$, en sortie du second circuit de récupération de fréquence, 332.

La solution proposée en Fig. 3 est complexe car elle requiert autant de circuits de récupération de fréquence que d'étages de synthèse de fréquence, ce qui conduit à une consommation en énergie élevée. Une telle solution n'est notamment pas envisageable pour des terminaux mobiles à faible autonomie.

Le but de la présente invention est par conséquent de proposer un dispositif de synthèse de fréquence permettant d'atteindre des ordres de multiplication élevés tout en étant relativement simple et de faible consommation en énergie.

**EXPOSÉ DE L'INVENTION**

La présente invention est définie par un dispositif de synthèse de fréquence comprenant :

un générateur de fréquence de base adapté à générer une pluralité $K$ de premiers signaux de base, lesdits premiers signaux de base étant des signaux d'horloge à phases non-recouvrantes, de même fréquence $f_1$ ;
un premier étage de synthèse comprenant une pluralité $K$ de premiers oscillateurs à alimentation commutée de structure identique et de même fréquence propre, $f_G^1$, les alimentations de ces $K$ premiers oscillateurs étant respectivement commutées par lesdits $K$ signaux de base, les signaux de sortie $( s_G^{1,i}, i = 1, ..., K )$ de ces $K$

premiers oscillateurs étant combinés pour fournir un second signal de base ($s_2$), de forme carrée et périodique, de fréquence $f_2 = Nf_1$ où $N$ est un nombre entier;

un second étage de synthèse comprenant un second oscillateur à alimentation commutée dont l'alimentation est commutée par le second signal de base, le signal de sortie de ce second oscillateur se présentant sous la forme de trains d'ondes, la fréquence de répétition de ces trains d'ondes étant égale à $f_2$ et la fréquence de ces ondes étant égale à $Mf_2$ où $M$ est un nombre entier, le second étage de synthèse comprenant en outre un circuit de discrimination de fréquence adapté à filtrer le signal de sortie $(s_G^2)$ du second oscillateur pour fournir un signal sinusoïdal à la fréquence $Mf_2$.

Avantageusement, les signaux de sortie des $K$ premiers oscillateurs sont sommés après avoir été respectivement mis en forme carrée dans $K$ circuits de mise en forme.

Typiquement, les $K$ premiers oscillateurs à alimentation commutée sont des oscillateurs de type VCO et sont commandés par une même tension de commande $(V_{ctrl}^1)$.

Le circuit de discrimination de fréquence est de préférence un oscillateur à verrouillage par injection dont la bande de résonance comprend la fréquence $Mf_2$.

Les rapports cycliques des premiers signaux de base sont avantageusement tous égaux à $1/K$.

Par exemple $K = 2$, les deux premiers signaux de base étant alors l'inverse l'un de l'autre.

Le générateur de fréquence de base peut notamment comprendre un oscillateur commandé en tension, verrouillé en fréquence et en phase au moyen d'une boucle PLL sur une fréquence de référence fournie par un résonateur à quartz.

## BRÈVE DESCRIPTION DES DESSINS

D'autres caractéristiques et avantages de l'invention apparaîtront à la lecture d'un mode de réalisation préférentiel de l'invention, décrit en référence aux figures jointes parmi lesquelles :

La Fig. 1 représente de manière schématique un dispositif de synthèse de fréquence connu de l'état de la technique ;

La Fig. 2 représente un chronogramme de signaux présents en différents points du dispositif de synthèse de la Fig. 1 ;

La Fig. 3 représente un dispositif de synthèse de fréquence d'ordre de multiplication élevé faisant appel à la mise en cascade de plusieurs étages de synthèse de fréquence ;

La Fig. 4 représente un chronogramme de signaux présents en différents points du dispositif de synthèse de fréquence de la Fig. 3 ;

La Fig. 5 représente de manière schématique un dispositif de synthèse de fréquence d'ordre de multiplication élevé et à structure simplifiée.

La Fig. 6 représente un chronogramme de signaux présents en différents points du dispositif de synthèse de fréquence à structure simplifiée de la Fig. 5 ;

La Fig. 7 représente le spectre du signal en sortie du second oscillateur à alimentation commutée de la Fig. 5 ;

La Fig. 8 représente de manière schématique un dispositif de synthèse de fréquence d'ordre de multiplication élevé, selon un premier mode de réalisation de l'invention ;

La Fig. 9 représente un chronogramme de signaux présents en différents points du dispositif de synthèse de fréquence de la Fig. 8 ;

La Fig. 10 représente le spectre du signal en sortie du second oscillateur à alimentation commutée de la Fig. 8 ;

La Fig. 11 représente de manière schématique un dispositif de synthèse de fréquence d'ordre de multiplication élevé, selon un second mode de réalisation de l'invention.

## EXPOSÉ DÉTAILLÉ DE MODES DE RÉALISATION PARTICULIERS

On considère à nouveau un dispositif de synthèse de fréquence à plusieurs étages de synthèse selon le principe de la Fig. 3. Une première idée à la base de l'invention est de se passer du circuit de récupération de fréquence pour obtenir un dispositif à structure simplifiée.

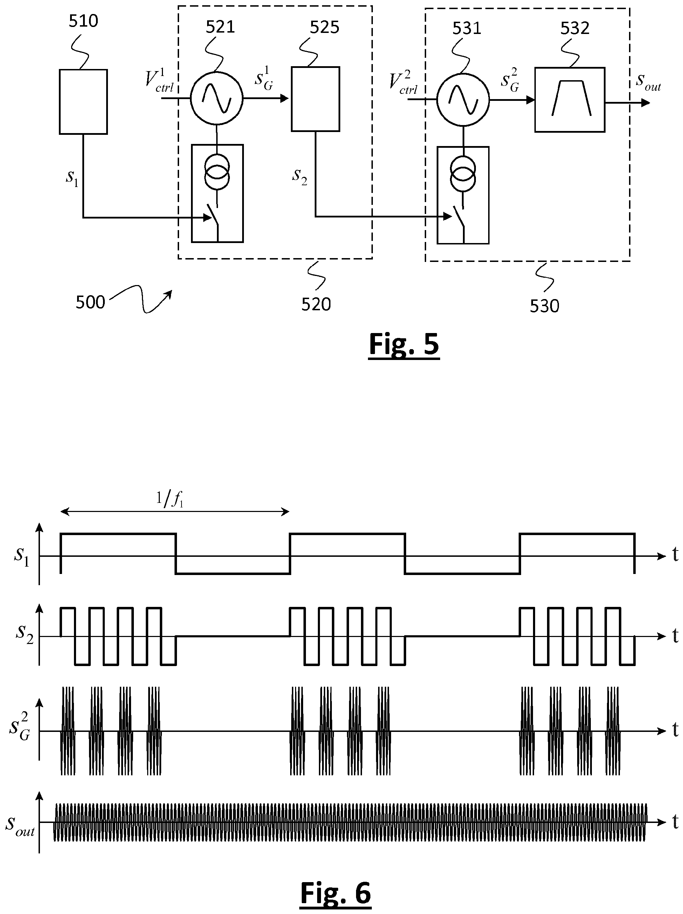

La Fig. 5 représente de manière schématique un tel dispositif de synthèse de fréquence d'ordre de multiplication élevé et à structure simplifiée.

Ce dispositif, 500, comprend un générateur de fréquence de base, 510, identique au générateur 310, un premier étage, 520, comportant un premier oscillateur à alimentation commutée, 521, un circuit de mise en forme (carrée ou pseudo-carrée), 525, et un second étage, 530, comprenant un deuxième oscillateur à alimentation commutée, 531, et un circuit de récupération de fréquence, 532.

La Fig. 6 représente un chronogramme de signaux présents en différents points du dispositif de synthèse de fréquence à structure simplifiée de la Fig. 5.

La première ligne du chronogramme correspond au signal $s_1$ en sortie du générateur de fréquence de base, servant à la commutation de l'alimentation du premier oscillateur 521.

La seconde ligne correspond au signal $s_2$ en sortie du circuit de mise en forme 525, servant à la commutation de l'alimentation du second oscillateur 531.

La troisième ligne correspond au signal $s_G^2$ en sortie du second oscillateur à alimentation commutée, 531.

La dernière ligne correspond au signal $s_{out}$ en sortie du circuit de récupération de fréquence 532.

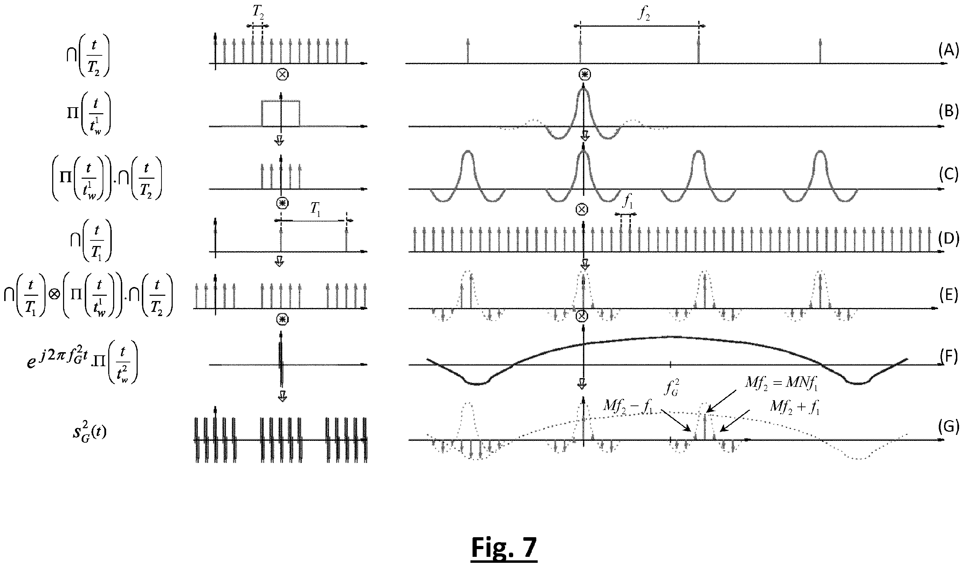

On remarque ici que le signal $s_G^2$ est nul lorsque le signal $s_1$ est nul, cette annulation intervenant au rythme de fréquence de base $f_1$ . En d'autres termes, le spectre $S_G^2$ de $s_G^2$ comporte un grand nombre de raies espacées de $f_1$, comme on peut le constater par ailleurs en Fig. 7.

On a représenté en Fig. 7 les différentes étapes (A) - (G) permettant de calculer le spectre $S_G^2$, avec, à gauche, la représentation de ces étapes dans le domaine temporel et à droite la représentation correspondante dans le domaine fréquentiel.

Le signal $s_G^2$ peut s'exprimer sous la forme :

$$s_G^2(t) = \left( e^{j2\pi f_G^2 t} . \Pi\left( \frac{t}{t_w^2} \right) \right) \otimes \left( \cap\left( \frac{t}{T_1} \right) \otimes \left( \Pi\left( \frac{t}{t_w^1} \right) \right) . \cap\left( \frac{t}{T_2} \right) \right) \qquad (3)$$

où $\Pi\left( \dfrac{t}{T} \right)$ représente la fonction porte de largeur $T$, $\cap\left( \dfrac{t}{T} \right) = \sum\limits_{k=-\infty}^{+\infty} \delta(t - kT)$ est un peigne de Dirac de période $T$, $t_w^1$ est la largeur de l'impulsion dans le signal de base ( $t_w^1 = \dfrac{T_1}{2}$ pour un signal de rapport cyclique $\dfrac{1}{2}$ ), $T_1 = 1/f_1$ , $T_2 = 1/f_2$, et $f_G^2 \approx M f_2 = N M f_1$ .

Les étapes (A) - (G) de construction du signal $s_G^2$ sont représentées dans la partie gauche de la figure, ces étapes correspondant aux opérations figurant de droite à gauche dans l'expression (3).

Le spectre $S_G^2$ s'exprime alors comme suit :

$$S_G^2(f) = \left( \text{sinc}\left( \frac{f - f_G^2}{2f_2} \right) \right) \left( \cap\left( \frac{f}{f_1} \right) . \left( \text{sinc}\left( \frac{f}{f_w^1} \right) \right) \otimes \cap\left( \frac{f}{f_2} \right) \right) \qquad (4)$$

avec $f_w^1 = 1/t_w^1$ ($2f_1$ si le rapport cyclique est de 1/2).

On remarque à la ligne (G) la présence d'un grand nombre de raies spectrales espacées de $f_1$, provenant de la répétition du motif $PT$ indiqué en Fig. 5. La sélection de la raie à la fréquence $NMf_1$ est très délicate et nécessite un oscillateur verrouillé par injection à très haut facteur de qualité (rapport de la fréquence propre de l'oscillateur sur largeur de bande de résonance). En outre, le fait de disposer d'une bande de résonance très étroite réduit considérablement la plage de verrouillage de l'oscillateur ILO.

Une seconde idée à la base de l'invention est de supprimer le peigne de raies espacées de $f_1$ dans le spectre $S_G^2$ en utilisant une pluralité de signaux de base à la fréquence $f_1$ et à phases non-recouvrantes comme exposé ci-après.

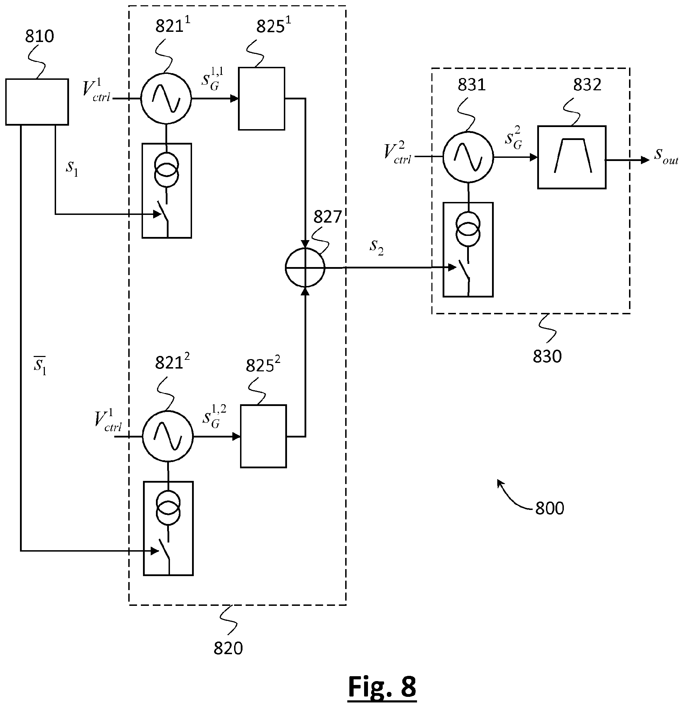

La Fig. 8 représente de manière schématique un dispositif de synthèse de fréquence d'ordre de multiplication élevé, selon un premier mode de réalisation de l'invention.

Le dispositif de synthèse de fréquence, 800, comprend un générateur de fréquence de base, 810, générant deux signaux d'horloge carrés à la fréquence $f_1$ et inverses l'un de l'autre, $s_1$ et $\bar{s}_1$. Ces deux signaux de base sont par exemple issus des sorties complémentaire Q et $\bar{Q}$ d'une bascule D dont l'entrée *CK* reçoit un signal d'horloge à la fréquence $2f_1$ fourni par un résonateur à quartz, 805. Alternativement, le signal $\bar{s}_1$ pourra être obtenu à partir de $s_1$ au moyen d'un inverseur, 807, comme représenté, le signal $s_1$ traversant par ailleurs un élément de retard, 806, de manière à ce que les signaux en sortie de 806 et 807 soient alignés temporellement. Bien entendu, on pourra de la même façon utiliser un oscillateur VCO asservi au moyen d'une boucle PLL sur une fréquence sous-multiple de $f_1$ fournie par le résonateur à quartz pour générer les signaux de base $s_1$ et $\bar{s}_1$.

Les signaux de base $s_1$ et $\bar{s}_1$ commutent respectivement l'alimentation de deux premiers oscillateurs à alimentation commutée, $821^1$ et $821^2$. Ces deux premiers oscillateurs sont des VCO de structure identique commandés par la même tension de commande, $V_{ctrl}^1$ et possèdent donc la même fréquence d'oscillation propre (c'est-à-dire en régime non commuté), $f_G^1$. Les oscillateurs $821^1$ et $821^2$ se verrouillent par conséquent en phase sur la même harmonique à la fréquence $Nf_1$.

Les signaux en sortie des oscillateurs $821^1$ et $821^2$, notés respectivement $s_G^{1,1}$ et $s_G^{1,2}$, sont des oscillations sinusoïdales pulsées, une impulsion de $s_G^{1,1}$ correspondant à un intervalle de tension nulle dans $s_G^{1,2}$ et réciproquement.

Les signaux $s_G^{1,1}$ et $s_G^{1,2}$ sont respectivement mis sous forme carrée dans les circuits de mise en forme $825^1$ et $825^2$. Après mise en forme, ces signaux sont sommés au moyen d'une porte OR, 827, pour fournir un second signal de base, $s_2$. A la différence des signaux $s_G^{1,1}$ et $s_G^{1,2}$, le signal $s_2 = s_G^{1,1} + s_G^{1,2}$ n'est pas pulsé et sa fréquence fondamentale est égale à $Nf_1$.

Ce second signal de base commute l'alimentation d'un deuxième oscillateur à alimentation commutée, 831. Cet oscillateur est de type VCO et est commandé par une tension de commande $V_{ctrl}^2$. La fréquence d'oscillation propre de l'oscillateur correspondant à cette tension de commande est notée $f_G^2$. L'oscillateur se verrouille en phase sur une harmonique de $f_2 = Nf_1$ à la fréquence $Mf_2 = MNf_1$, la tension de commande $V_{ctrl}^2$ permet de sélectionner l'ordre *M* de l'harmonique. Le signal $s_G^2$ en sortie de l'oscillateur 831 se présente sous la forme de trains d'ondes se répétant à la fréquence de répétition $f_2$, la fréquence des oscillations au sein d'un train d'onde étant égale à $Mf_2$.

Le signal $s_G^2$ est fourni à un circuit de récupération (ou de discrimination) de fréquence, 832, réalisé sous la forme d'un oscillateur ILO comme indiqué précédemment. Lorsque la fréquence $Mf_2$ du signal injecté tombe dans la bande de fréquence de résonance de l'oscillateur ILO, l'oscillateur se verrouille en phase sur le signal d'injection pour fournir un signal sinusoïdal (non pulsé) à la fréquence $Mf_2$, stable en fréquence et en phase.

Le circuit de récupération de fréquence 832 ne nécessite pas un facteur de qualité aussi élevé que le circuit de récupération de fréquence 532. En effet, le spectre $S_G^2$ de $s_G^2$ ne présentant pas des raies espacées de $f_1$ mais seulement de $f_2 = Nf_1$, la contrainte sur la largeur de bande de résonance peut être relaxée d'un facteur N.

En pratique, on choisira les paramètres caractéristiques de l'oscillateur ILO de manière à ce que la fréquence propre de l'oscillateur ILO soit proche de la fréquence de consigne et l'on fera varier $V_{ctrl}^1$ et/ou $V_{ctrl}^2$ de manière à ce qu'une raie se situe au plus près de $Mf_2$ pour obtenir la puissance de sortie maximale.

L'homme du métier comprendra que le dispositif de synthèse de fréquence de la Fig. 8 comprend deux étages de synthèse, 820 et 830, seul le second est équipé d'un circuit de discrimination de fréquence, ce qui permet de réduire la consommation en énergie du dispositif.

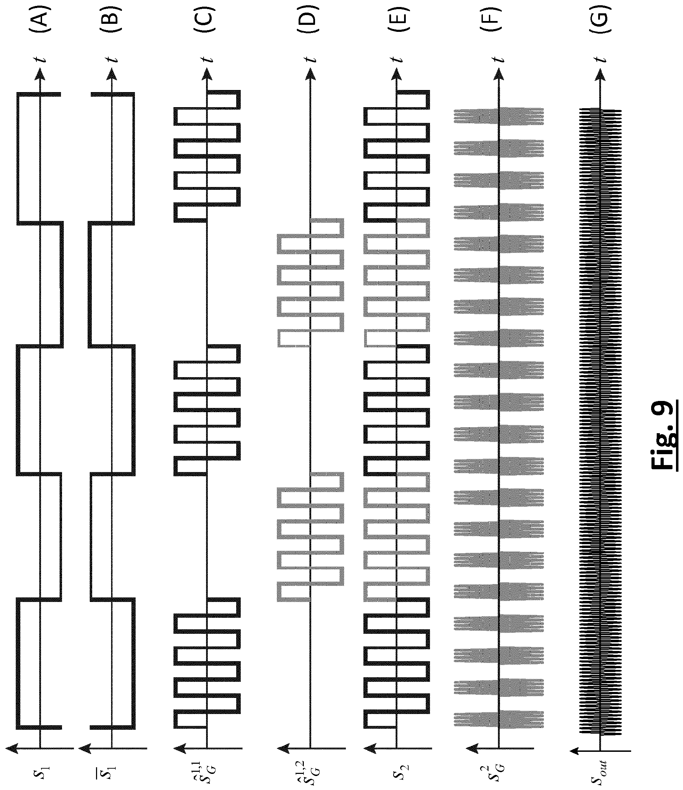

La Fig. 9 représente un chronogramme de signaux présents en différents points du dispositif de synthèse de fréquence de la Fig. 8.

Les deux premières lignes (A) et (B) du chronogramme représentent les signaux de base $s_1$ et $\bar{s}_1$. On a supposé

ici que les rapports cycliques de ces signaux étaient égaux à 1/2 . Dans le cas général, ils peuvent être égaux à $\eta$ et 1-$\eta$ même si la valeur $\eta$=1/2 est préférée.

Les deux lignes suivantes (C) et (D) du chronogramme représentent les signaux $s_G^{1,1}$ et $s_G^{1,2}$ fournis par les deux premiers oscillateurs à alimentation commutée, après qu'ils ont été mis en forme dans les circuits $825^1$ et $825^2$. La ligne (E) représente quant à elle le second signal de base $s_2$.

La ligne (F) du chronogramme représente le signal $s_G^2$ en sortie du troisième oscillateur à alimentation commutée.

Enfin, la dernière ligne (G) représente le signal de sortie, $s_{out}$, fourni par le circuit de récupération de fréquence.

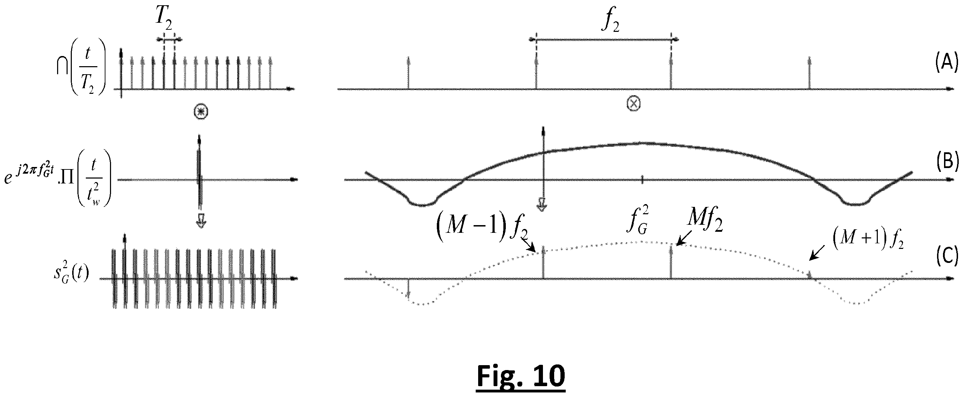

La Fig. 10 représente le spectre du signal en sortie du second oscillateur à alimentation commutée de la Fig. 8.

La partie gauche de la Fig. donne une représentation temporelle des signaux et la partie gauche la représentation fréquentielle correspondante.

Du fait de la complémentarité des signaux $s_1$ et $\bar{s}_1$, le signal de commutation $s_2$ n'est pas pulsé et le signal $s_G^2(t)$ s'exprime simplement sous la forme :

$$s_G^2(t) = e^{j2\pi f_G^2 t}.\Pi\left(\frac{t}{t_w^2}\right) \otimes \cap\left(\frac{t}{T_2}\right) \tag{5}$$

Le spectre de ce signal est donc donné par :

$$S_G^2(f) = \left(\operatorname{sinc}\left(\frac{f - f_G^2}{2f_2}\right)\right).\cap\left(\frac{f}{f_2}\right) \tag{6}$$

On remarque que les raies à intervalles de $f_1$ ont été éliminées et qu'il est par conséquent beaucoup plus facile de réaliser le circuit discriminateur de fréquence 832 pour sélectionner la fréquence de consigne.

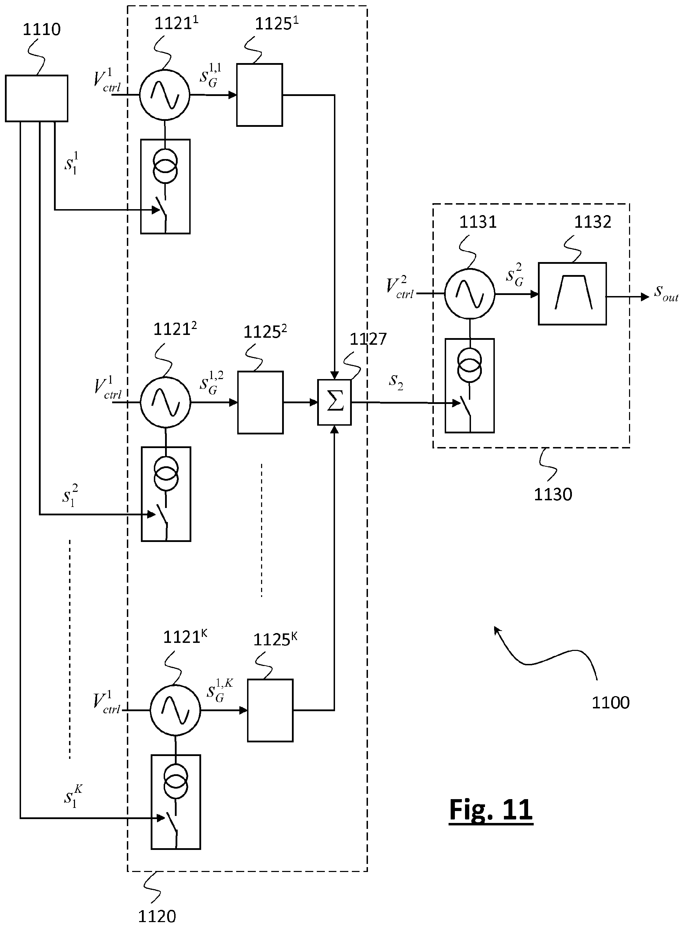

La Fig. 11 représente de manière schématique un dispositif de synthèse de fréquence d'ordre de multiplication élevé, selon un second mode de réalisation de l'invention.

Ce second mode de réalisation peut être considéré comme une généralisation du premier dans la mesure où il utilise comme signaux de base des horloges de fréquence $f_1$ à phases non-recouvrantes, notées $s_1^i$, $i = 1,...,K$.

On appelle signaux à phases non-recouvrantes des signaux carrés de même fréquence, $s^i$, $i = 1,...,K$, pouvant conventionnellement prendre des valeurs logiques 0 ou 1, tels que :

$$s^i * s^j = 0 , \; \forall i \neq j \; \text{et} \; \sum_{i=1}^{K} s^i = 1 \tag{7}$$

où * signifie la multiplication logique (AND) et la somme est une somme logique (OR).

Dans ce mode de réalisation, le générateur de fréquence de base, 1110, génère une pluralité $K$ de premiers signaux de base $s_1^i$, $i = 1,...,K$ de fréquence $f_1$ et à phases non-recouvrantes. Les rapports cycliques $\eta_i$ de ces premiers signaux de base peuvent être distincts mais vérifient la relation $\sum_{i=1}^{K}\eta_i = 1$ . De préférence toutefois, les rapports cycliques $\eta_i$ seront choisis tous égaux à 1/$K$. L'entier $K$ sera avantageusement choisi égal à une puissance de 2 pour des raisons de facilité d'implémentation.

Les premiers signaux de base $s_1^i$, $i = 1,...,K$ commutent respectivement l'alimentation de $K$ oscillateurs à alimentation commutée, $1121^1$, ..., $1121^K$.

Ces $K$ oscillateurs sont des VCO de structure identique commandés par une même tension de commande,

$V_{ctrl}^1$, et possèdent donc la même fréquence d'oscillation propre $f_G^1$. Ils se verrouillent en phase sur la même harmonique à la fréquence $Nf_1$.

Chacun des signaux en sortie des oscillateurs $1121^1$, ..., $1121^K$ notés $s_G^{1,i}$, $i = 1,...,K$, présente des oscillations sinusoïdales pulsées, chaque impulsion de $s_G^{1,i}$ correspondant à un intervalle de tension nulle dans les signaux $s_G^{1,j}$, $j \neq i$.

Les signaux $s_G^{1,i}$, $i = 1,..., K$ sont respectivement mis sous forme carrée dans les circuits de mise en forme $1125^1$,..., $1125^K$. Après mise en forme, ces signaux sont sommés au moyen d'une porte OR, 827, pour fournir un second signal de base, $s_2$. A la différence des signaux $s_G^{1,i}$, $i = 1,...,K$, le signal $s_2 = \sum_{i=1}^{K} s_G^{1,i}$ n'est pas pulsé et sa fréquence fondamentale est égale à $Nf_1$.

Le second signal de base $s_2$ commute l'alimentation du $(K+1)^{ième}$ oscillateur à alimentation commutée, 1131, Cet oscillateur se verrouille en phase sur une harmonique de $f_2 = Nf_1$ à la fréquence $Mf_2 = MNf_1$ comme dans le premier mode de réalisation. Le signal $s_G^2$ en sortie de l'oscillateur est fourni au circuit de récupération de fréquence, 1132, réalisé sous la forme d'un oscillateur ILO, pour fournir un signal sinusoïdal non pulsé, $s_{out}$, à la fréquence $Mf_2$, stable en fréquence et en phase.

Le dispositif de synthèse de fréquence de la Fig. 11 comprend deux étages de synthèse, 1120 et 1130, seul le second est équipé d'un circuit discriminateur de fréquence pour fournir la fréquence de consigne.

**Revendications**

1.  Dispositif de synthèse de fréquence comprenant :

    un générateur de fréquence de base (810, 1110) adapté à générer une pluralité $K$ de premiers signaux de base, lesdits premiers signaux de base étant des signaux d'horloge à phases non-recouvrantes, de même fréquence $f_1$ ;
    un premier étage de synthèse (820, 1120) comprenant une pluralité $K$ de premiers oscillateurs à alimentation commutée de structure identique et de même fréquence propre, $f_G^1$, les alimentations de ces $K$ premiers oscillateurs étant respectivement commutées par lesdits $K$ signaux de base, les signaux de sortie ($s_G^{1,i}$, $i = 1,...,K$) de ces $K$ premiers oscillateurs étant combinés pour fournir un second signal de base ($s_2$), de forme carrée et périodique, de fréquence $f_2 = Nf_1$ où $N$ est un nombre entier ;
    un second étage de synthèse (830, 1130) comprenant un second oscillateur à alimentation commutée (831, 1131) dont l'alimentation est commutée par le second signal de base, le signal de sortie de ce second oscillateur se présentant sous la forme de trains d'ondes, la fréquence de répétition de ces trains d'ondes étant égale à $f_2$ et la fréquence de ces ondes étant égale à $Mf_2$ où $M$ est un nombre entier, le second étage de synthèse comprenant en outre un circuit de discrimination de fréquence (832, 1132) adapté à filtrer le signal de sortie $(s_G^2)$ du second oscillateur pour fournir un signal sinusoïdal à la fréquence $Mf_2$.

2.  Dispositif de synthèse de fréquence selon la revendication 1, dans lequel les signaux de sortie des $K$ premiers oscillateurs sont sommés après avoir été respectivement mis en forme carrée dans $K$ circuits de mise en forme ($825^1, 825^2$; $1125^1$,..., $1125^K$).

3.  Dispositif de synthèse de fréquence selon la revendication 1 ou 2, dans lequel les $K$ premiers oscillateurs à alimentation commutée sont des oscillateurs de type VCO et qu'ils sont commandés par une même tension de commande $(V_{ctrl}^1)$.

4.  Dispositif de synthèse de fréquence selon l'une des revendications précédentes, dans lequel le circuit de discrimination de fréquence est un oscillateur à verrouillage par injection dont la bande de résonance comprend la fréquence $Mf_2$.

**5.** Dispositif de synthèse de fréquence selon l'une des revendications précédentes, dans lequel les rapports cycliques des premiers signaux de base sont tous égaux à 1/$K$.

**6.** Dispositif de synthèse de fréquence selon l'une des revendications précédentes, dans lequel $K$ = 2, les deux premiers signaux de base étant l'inverse l'un de l'autre.

**7.** Dispositif de synthèse de fréquence selon l'une des revendications précédentes, dans lequel le générateur de fréquence de base (810, 1110) comprend un oscillateur commandé en tension, verrouillé en fréquence et en phase au moyen d'une boucle PLL sur une fréquence de référence fournie par un résonateur à quartz.

**Patentansprüche**

**1.** Frequenzsynthesevorrichtung, enthaltend:

einen Grundfrequenzgenerator (810, 1110), der dazu ausgelegt ist, eine Vielzahl $K$ von ersten Basissignalen zu erzeugen, wobei die ersten Basissignale nicht überlappende Phasentaktsignale der gleichen Frequenz $f_1$ sind;
eine erste Synthesestufe (820, 1120) mit einer Vielzahl $K$ von ersten versorgungsgeschalteten Oszillatoren identischer Struktur und gleicher Eigenfrequenz $f_G^1$, wobei die Versorgungen dieser ersten $K$ Oszillatoren jeweils durch die $K$ Basissignale geschaltet werden, wobei die Ausgangssignale ($s_G^{1,i}$, $i$ = 1, ..., $K$) dieser ersten $K$ Oszillatoren kombiniert werden, um ein zweites Basissignal ($s_2$) mit quadratischer, periodischer Form der Frequenz $f_2$ = $Nf_1$ bereitzustellen, wobei $N$ eine ganze Zahl ist;
eine zweite Synthesestufe (830, 1130) mit einem zweiten versorgungsgeschalteten Oszillator (831, 1131), dessen Versorgung durch das zweite Basissignal geschaltet wird, wobei das Ausgangssignal dieses zweiten Oszillators in Form von Wellenzügen vorliegt, wobei die Wiederholungsfrequenz dieser Wellenzüge gleich $f_2$ und die Frequenz dieser Wellen gleich $Mf_2$ ist, wobei M eine ganze Zahl ist, wobei die zweite Synthesestufe ferner eine Frequenzdiskriminatorschaltung (832, 1132) aufweist, die dazu geeignet ist, das Ausgangssignal $(s_G^2)$ des zweiten Oszillators auszufiltern, um ein sinusförmiges Signal mit der Frequenz $Mf_2$ bereitzustellen.

**2.** Frequenzsynthesevorrichtung nach Anspruch 1, wobei die Ausgangssignale der ersten $K$ Oszillatoren summiert werden, nachdem sie jeweils in $K$ Formgebungsschaltungen (825[1], 825[2]; 1125[1], ..., 1125[K]) quadratisch geformt wurden.

**3.** Frequenzsynthesevorrichtung nach Anspruch 1 oder 2, wobei die versorgungsgeschalteten ersten $K$ Oszillatoren Oszillatoren vom VCO-Typ sind und durch dieselbe Steuerspannung $(V_{ctri}^1)$ gesteuert werden.

**4.** Frequenzsynthesevorrichtung nach einem der vorstehenden Ansprüche, wobei die Frequenzdiskriminatorschaltung ein injektionsverriegelter Oszillator ist, dessen Resonanzband die Frequenz $Mf_2$ umfasst.

**5.** Frequenzsynthesevorrichtung nach einem der vorstehenden Ansprüche, wobei die Tastverhältnisse der ersten Basissignale alle gleich 1/$K$ sind.

**6.** Frequenzsynthesevorrichtung nach einem der vorstehenden Ansprüche, wobei $K$ = 2 ist, wobei die beiden ersten Basissignale zueinander invers sind.

**7.** Frequenzsynthesevorrichtung nach einem der vorstehenden Ansprüche, wobei der Grundfrequenzgenerator (810, 1110) einen spannungsgesteuerten Oszillator enthält, der in Frequenz und Phase mittels einer PLL-Schleife auf eine von einem Quarzresonator bereitgestellte Referenzfrequenz verriegelt ist.

**Claims**

1.  A frequency synthesis device comprising:

    a base frequency generator (810, 1110) adapted to generate a plurality $K$ of first base signals, said first base signals being non-covering phase clock signals, with a same frequency $f1$;
    a first synthesis stage (820, 1120) comprising a plurality $K$ of first switching power supply oscillators with an identical structure and the same eigenfrequency, $f_G^1$, the power supplies of these first $K$ oscillators being respectively switched by said $K$ base signals, the output signals ( $s_G^{1,i}$, $l$=1, ..., $K$) of these first $K$ oscillators being combined to provide a second square-shaped periodic base signal ($s_2$), with a frequency $f_2 = Nf_1$ where $N$ is an integer;
    a second synthesis stage (830, 1130) comprising a second switching power supply oscillator (831, 1131) the power supply of which is switched by the second base signal, the output signal of this second oscillator being as trains of waves, the repetition frequency of these trains of waves being equal to $f_2$ and the frequency of these waves being equal to $Mf_2$ where $M$ is an integer, the second synthesis stage further comprising a frequency discrimination circuit (832, 1132) adapted to filter the output signal ( $s_G^2$ ) of the second oscillator to provide a sine wave signal at the frequency $Mf_2$.

2.  The frequency synthesis device according to claim 1, wherein the output signals of the first $K$ oscillators are summed after being respectively square wave-shaped in K shaping circuits ($825^1$, $825^2$; $1125^1$, ..., $1125^K$).

3.  The frequency synthesis device according to claim 1 or 2, wherein the first $K$ switching power supply oscillators are VCO type oscillators and they are controlled by a same control voltage ( $V_{ctrl}^1$ ).

4.  The frequency synthesis device according to one of the previous claims, wherein the frequency discrimination circuit is an injection lock oscillator the resonance band of which comprises the frequency $Mf_2$.

5.  The frequency synthesis device according to one of the previous claims, wherein the duty factors of the first base signals are all equal to $1/K$.

6.  The frequency synthesis device according to one of the previous claims, wherein $K$ = 2, the first two base signals being the inverse of each other.

7.  The frequency synthesis device according to one of the previous claims, wherein the base frequency generator (810, 1110) comprises an oscillator which is voltage controlled, frequency and phase locked by means of a PLL loop to a reference frequency provided by a quartz resonator.

**Fig. 1**

**Fig. 2**

**Fig. 3**

**Fig. 4**

**Fig. 5**

**Fig. 6**

**Fig. 7**

**Fig. 8**

**Fig. 9**

**Fig. 10**

**Fig. 11**

## RÉFÉRENCES CITÉES DANS LA DESCRIPTION

**Documents brevets cités dans la description**

- FR 3006131 A1

- FR 2983370 A

**Littérature non-brevet citée dans la description**

- **M. TIEBOUT.** A 50 GHz direct injection locked oscillator topology as low power frequency divider in 0.13 μm CMOS. *Proc. of the 29th European Solid State Circuits Conference,* 16 Septembre 2003, 73-76